# EUROPEAN PATENT APPLICATION

(11) **EP 4 563 718 A1**
(43) Date of publication of application: **04.06.2025**
(21) Application number: 23844746.0
(22) Date of filing: 21.07.2023
(51) Int. Cl.: C23C 14/06, C23C 14/30, C23C 14/32, B22F 3/00

(54) **LANTHANUM-GADOLINIUM-SAMARIUM-BASED HIGH-ENTROPY THERMAL BARRIER COATING AND PREPARATION METHOD THEREFOR**

(30) Priority: 29.07.2022 CN 202210913422
(71) Applicant: AECC Beijing Institute of Aeronautical Materials, Beijing 100095 (CN)
(72) Inventor: SHEN, Zaoyu, Beijing 100095 (CN); LIU, Guanxi, Beijing 100095 (CN); DAI, Jianwei, Beijing 100095 (CN); MOU, Rende, Beijing 100095 (CN); HE, Limin, Beijing 100095 (CN)
(74) Representative: Osha BWB
(86) International application number: PCT/CN2023/000081
(87) International publication number: WO 2024/021527

(57) **Abstract**

The invention belongs to the technical field of aeronautical engine thermal barrier coatings and relates to a lanthanum-gadolinium-samarium-based high-entropy thermal barrier coating material and a preparation method therefor. The lanthanum-gadolinium-samarium-based high-entropy target material has a molecular formula of La_{0.4}Gd_{0.4}Sm_{0.4}A_{0.4}B_{0.4}Zr₂O₇, where A and B are different rare earth elements. The following deposition process parameters are selected: a vacuum degree of a deposition chamber of less than 5 × 10⁻⁴ Torr; a beam intensity of electron beam of 1.6 A to 1.8 A; a temperature of the sample of 1,000 °C to 1,050 °C; an evaporation time of 30 min to 60 min; and ultimately a lanthanum-gadolinium-samarium-based high-entropy thermal barrier coating is obtained on the rotating sample. The thermal barrier coating material of the invention has a thermal expansion coefficient that is relatively close to that of YSZ and exhibits low thermal conductivity. The lanthanum-gadolinium-samarium-based high-entropy thermal barrier coatings by electron beam physical vapor deposition exhibits a unique columnar crystal structure and a long service life. The invention can not only ensure the reduction of the thermal conductivity of the coating, but also increase the service temperature of the coating, and can also remedy the practical problems of poor service life and low thermal expansion coefficient of the coating.

## Description

### TECHNICAL FIELD

The invention belongs to the technical field of aeronautical engine thermal barrier coatings and relates to lanthanum-gadolinium-samarium-based high-entropy thermal barrier coating and a preparation method therefor.

### BACKGROUND

At present, with the continuous improvement of the thrust and working efficiency of gas turbines, the gas inlet temperature is getting higher and higher, and the operating temperature of nickel-based superalloy used in turbine blades and other hot end components has gradually approached its service temperature limit. Thermal barrier coatings (TBCs) are related to a surface protection technology that utilizes the high temperature resistance, erosion resistance, corrosion resistance, and low thermal conductivity of ceramic materials and compounds them, in a form of coating, with a metal substrate. The application of TBCs is to improve the operating temperature of metal components, enhance the high temperature resistance of hot end components, prolong the service life of hot end components, and improve the efficiency of the engine. At present, the service temperature of the widely used YSZ (ZrO₂ partially stabilized with 6 wt.% - 8 wt.% Y₂O₃) thermal barrier coating materials cannot exceed 1200 °C. During the cooling process, a volume expansion occurs due to a production of monoclinic phase caused by phase transition, which leads to the failure of the coating. However, the long-term service temperature of thermal barrier coating materials must exceed 1200 °C in next-generation high-performance aeronautical engines. Therefore, research on new thermal barrier coating materials has become a key issue in the development of the next-generation high-performance aeronautical engine.

### SUMMARY

Aiming at the defects of the above-mentioned prior art, the invention provides a lanthanum-gadolinium-samarium-based high-entropy thermal barrier coating and a preparation method therefor. The invention aims to realize lanthanum-gadolinium-samarium-based high entropy and solve the problem that the service life of a single zirconate thermal barrier coating is short and the service temperature of YSZ is not higher than 1200 °C, while reducing the thermal conductivity of the material and improving the thermal expansion coefficient of the material.

In order to solve this technical problem, the technical solution of the invention is as follows:
In an aspect, the invention provides a lanthanum-gadolinium-samarium-based high-entropy thermal barrier coating material. The lanthanum-gadolinium-samarium-based high-entropy thermal barrier coating material has a chemical molecular formula of La_{0.4}Gd_{0.4}Sm_{0.4}A_{0.4}B_{0.4}Zr₂O₇, wherein A and B are different rare earth elements other than lanthanum, gadolinium, and samarium.

The rare earth element is Ce, Pr, Nd, Yb, Er, Dy or Eu.

In another aspect, the invention provides a method for preparing a lanthanum-gadolinium-samarium-based high-entropy thermal barrier coating material, the method including the following steps:
Step One, mixing raw materials La₂O₃, Gd₂O₃, Sm₂O₃, A₂O₃, B₂O₃ and ZrO₂ according to a ratio of a molecular formula of the material, and synthesizing a lanthanum-gadolinium-samarium-based high-entropy target material by a high-temperature solid-state method at a synthesis temperature of 2,000 °C to 2,200 °C;
Step Two, preparing NiCoCrAlYHf as a metal bottom layer of the thermal barrier coating by using a vacuum arc plating device at a voltage of 650 V to 700 V and a current of 15 A to 25 A; and
Step Three, mounting the lanthanum-gadolinium-samarium-based high-entropy target material into an electron beam physical vapor deposition device, and preparing the lanthanum-gadolinium-samarium-based high-entropy thermal barrier coating on the NiCoCrAlYHf bottom layer by electron beam evaporation of the lanthanum-gadolinium-samarium-based high-entropy target material at a beam intensity of the electron beam of 1.6 A to 1.8 A and a temperature of the sample of 1,000 °C to 1,050 °C.

In Step One, the raw materials La₂O₃, Gd₂O₃, Sm₂O₃, A₂O₃, B₂O₃ and ZrO₂ have purities of more than or equal to 99%.

In Step One, the mixing of the raw materials is by mechanical ball milling for a time more than or equal to 16 hours.

In Step One, a synthesis time of the high-temperature solid-state method is more than or equal to 20 hours.

In Step Two, the vacuum arc plating device has a vacuum degree of less than 1 × 10⁻² Pa and a deposition time of greater than or equal to 100 min.

In Step Three, the electron beam physical vapor deposition device has a vacuum degree of less than 5×10⁻² Pa; the electron beam physical vapor deposition of the thermal barrier coating has an evaporation time of 30 min to 60 min; and the thermal barrier coating is cooled inside the device to below 200 °C, the cooling being natural cooling.

The invention has the following beneficial effects. As a novel thermal barrier coating material, the invention adopts the design of high-entropy rare earth zirconate, whereby a high-entropy rare earth zirconate (Re_{X})₂Zr₂O₇ is selected as a thermal barrier coating material. In comparison with introducing high entropy on both the rare earth sites and the Zr sites, introducing high entropy only on the rare earth sites can well improve the high-temperature phase stability of the material, while a high chemical compatibility of the material can be well retained due to the single Zr sites. Furthermore, in the later process of coating preparation, it is easier to stabilize the phase structure of the material and less likely to produce evaporation segregation. The lanthanum-gadolinium-samarium-based high-entropy thermal barrier coating prepared by the electron beam physical vapor deposition technique does not undergo phase change after long-term heat treatment at high temperatures and exhibits high phase stability. Their thermal expansion coefficient is close to that of YSZ, and they have lower thermal conductivity and better thermal expansion coefficient. Furthermore, the use of electron beam physical vapor deposition to prepare the lanthanum-gadolinium-samarium-based high-entropy thermal barrier coating will allow the thermal barrier coating to have a unique columnar crystal structure and allow the coating to have better strain tolerance and better thermal cycling performance.

### BRIEF DESCRIPTION OF DRAWINGS

FIG. 1 is a schematic diagram of the thermal conductivity of Embodiment 2;
FIG. 2 is a schematic diagram of the thermal expansion coefficient of Embodiment 2;
FIG. 3 is a schematic diagram of the thermal life of Embodiment 2;
FIG. 4 is a schematic diagram of the columnar crystal structure of the invention.

### DETAILED DESCRIPTION

In order to make the objectives, technical solutions and advantages of the embodiments of the invention clearer, the technical solutions in the embodiments of the invention will be described clearly and thoroughly with reference to the drawings in the embodiments of the invention. It is to be understood that the described embodiments are some, but not all, embodiments of the invention. Based on the embodiments in the invention, all other embodiments obtained by one of ordinary skill in the art without any creative effort shall fall within the protection scope of the invention.

Features of various aspects of embodiments of the invention will be described in detail below. In the following detailed description, numerous specific details are provided in order to provide a thorough understanding of the invention. However, it will be apparent to one of ordinary skill in the art that the invention may be implemented without these specific details. The following description of the embodiments is only for a better understanding of the invention by illustrating examples of the invention. The invention is not limited to any specific configuration and method provided below, but covers all modifications, replacements, and the like, of the product structures, methods covered without departing from the spirit of the invention.

In the various drawings and the following description, well-known structures and techniques are not shown in order to avoid unnecessarily obscuring the invention.

The lanthanum-gadolinium-samarium-based high-entropy thermal barrier coating material of the invention has a chemical molecular formula of La_{0.4}Gd_{0.4}Sm_{0.4}A_{0.4}B_{0.4}Zr₂O₇, where A and B are different rare earth elements.

A method for preparing the lanthanum-gadolinium-samarium-based high-entropy thermal barrier coating material includes the following steps:
mixing raw materials La₂O₃, Gd₂O₃, Sm₂O₃, A₂O₃, B₂O₃ and ZrO₂ according to the ratio of the molecular formula of the material, where the raw materials have purities of more than or equal to 99%, the mixing is by mechanical ball milling for a time more than or equal to 16 hours; synthesizing a lanthanum-gadolinium-samarium-based high-entropy target material by a high-temperature solid-state method at a synthesis temperature of 2000-2200 °C for a synthesis time of more than or equal to 20 hours; preparing NiCoCrAlYHf as a metal bottom layer of the thermal barrier coating by using a vacuum arc plating device, at a vacuum degree of less than 1 × 10⁻² Pa, a voltage of 650 V to 700 V, and a current of 15 A to 25 A, for a deposition time of greater than or equal to 100 min; and mounting the prepared target material into an electron beam physical vapor deposition device, preparing the thermal barrier coating at a vacuum degree of less than 5 × 10⁻² P and a beam intensity of electron beam of 1.6 A to 1.8 A for an evaporation time of 30 min to 60 min, and naturally cooling it inside the device to below 200 °C.

In the above process, the synthesis temperature of the lanthanum-gadolinium-samarium-based high-entropy target material synthesized by the high-temperature solid-state method, the voltage and the current in the preparation of the NiCoCrAlYHf metal bottom layer, and the beam intensity of the electron beam are crucial and important. By determining the synthesis temperature of the high-temperature solid-state method, the generation of microcracks in the target material can be well avoided, and the homogeneity of the synthesized target material can be improved. By selecting NiCoCrAlYHf as the metal bottom layer of the thermal barrier coating, the service life of the thermal barrier coating can be greatly increased. By regulating the voltage and current, the prepared NiCoCrAlYHf metal bottom layer can be made into an equiaxed crystal structure. By regulating the beam intensity of the electron beam, the preparation of a unique columnar crystal structure can be realized. As a result, the service life of the thermal barrier coating is greatly increased.

### Embodiment 1

(1) Composition of raw materials: the lanthanum-gadolinium-samarium-based high-entropy thermal barrier coating material has a chemical molecular formula of La_{0.4}Gd_{0.4}Sm_{0.4}A_{0.4}B_{0.4}Zr₂O₇, where A is rare earth element Ce, and B is rare earth element Pr.
(2) High-temperature solid-state synthesis: the raw materials were mechanically ball milled for 20 h, and a lanthanum-gadolinium-samarium-based high-entropy target material was synthesized by a high-temperature solid-state method at 2,050 °C for a synthesis time of 24 h.
(3) Preparation of bottom layer: a vacuum arc plating device was used to prepare NiCoCrAlYHf as a metal bottom layer of the thermal barrier coating, at a vacuum degree of less than 1 × 10⁻² Pa, a voltage of 675 V, and a current of 18 A, for a deposition time of 175 min.
(4) Preparation of thermal barrier coating: the lanthanum-gadolinium-samarium-based high-entropy target material was mounted into an electron beam physical vapor deposition device. The deposition process parameters are as follows: a vacuum degree of less than 5 × 10⁻² Pa; a beam intensity of electron beam of 1.65 A; an evaporation time of 60 min; and after cooling to below 200 °C, the deposition device was opened to obtain the lanthanum-gadolinium-samarium-based high-entropy thermal barrier coating.

The prepared lanthanum-gadolinium-samarium-based high-entropy thermal barrier coating has a thermal conductivity of 0.86 W/(mK) at 1000 °C, a thermal expansion coefficient of 11.35 × 10⁻⁶ K⁻¹, and a thermal life of 898 hours.

### Embodiment 2

(1) Composition of raw materials: the lanthanum-gadolinium-samarium-based high-entropy thermal barrier coating material has a chemical molecular formula of La_{0.4}Gd_{0.4}Sm_{0.4}A_{0.4}B_{0.4}Zr₂O₇, where A is rare earth element Yb, and B is rare earth element Ce.
(2) High-temperature solid-state synthesis: the raw materials were mechanically ball milled for 24 h, and a lanthanum-gadolinium-samarium-based high-entropy target material was synthesized by a high-temperature solid-state method at 2,100 °C for a synthesis time of 28 h.
(3) Preparation of bottom layer: a vacuum arc plating device was used to prepare NiCoCrAlYHf as a metal bottom layer of the thermal barrier coating, at a vacuum degree of less than 1 × 10⁻² Pa, a voltage of 700 V, and a current of 20 A, for a deposition time of 150 min.
(4) Preparation of thermal barrier coating: the lanthanum-gadolinium-samarium-based high-entropy target material was mounted into an electron beam physical vapor deposition device. The deposition process parameters are as follows: a vacuum degree of less than 5 × 10⁻² Pa; a beam intensity of electron beam of 1.70 A; an evaporation time of 50 min; and after cooling to below 200 °C, the deposition device was opened to obtain the lanthanum-gadolinium-samarium-based high-entropy thermal barrier coating.

The prepared lanthanum-gadolinium-samarium-based high-entropy thermal barrier coating has a thermal conductivity of 0.91 W/(mK) at 1000 °C, a thermal expansion coefficient of 11.05 × 10⁻⁶ K⁻¹, and a thermal life of 818 hours.

### Embodiment 3

(1) Composition of raw materials: the lanthanum-gadolinium-samarium-based high-entropy thermal barrier coating material has a chemical molecular formula of La_{0.4}Gd_{0.4}Sm_{0.4}A_{0.4}B_{0.4}Zr₂O₇, where A is rare earth element Eu, and B is rare earth element Pr.
(2) High-temperature solid-state synthesis: the raw materials were mechanically ball milled for 28 h, and a lanthanum-gadolinium-samarium-based high-entropy target material was synthesized by a high-temperature solid-state method at 2,150 °C for a synthesis time of 30 h.
(3) Preparation of bottom layer: a vacuum arc plating device was used to prepare NiCoCrAlYHf as a metal bottom layer of the thermal barrier coating, at a vacuum degree of less than 1 × 10⁻² Pa, a voltage of 725 V, and a current of 22 A, for a deposition time of 125 min.
(4) Preparation of thermal barrier coating: the lanthanum-gadolinium-samarium-based high-entropy target material was mounted into an electron beam physical vapor deposition device. The deposition process parameters are as follows: a vacuum degree of less than 5 × 10⁻² Pa; a beam intensity of electron beam of 1.75 A; an evaporation time of 40 min; and after cooling to below 200 °C, the deposition device was opened to obtain the lanthanum-gadolinium-samarium-based high-entropy thermal barrier coating.

The prepared lanthanum-gadolinium-samarium-based high-entropy thermal barrier coating has a thermal conductivity of 0.95 W/(mK) at 1000 °C, a thermal expansion coefficient of 10.95 × 10⁻⁶ K⁻¹, and a thermal cycling life of 830 hours.

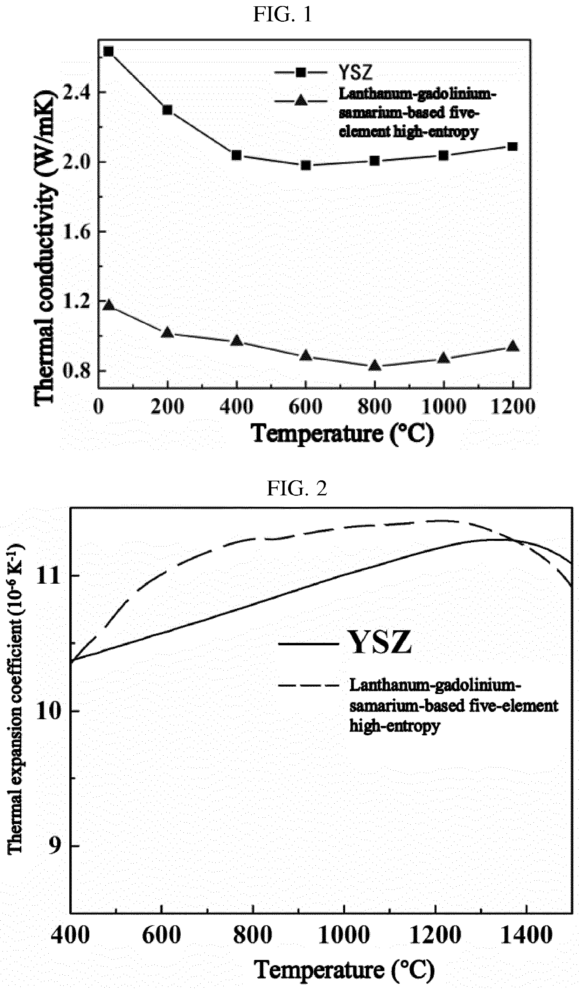

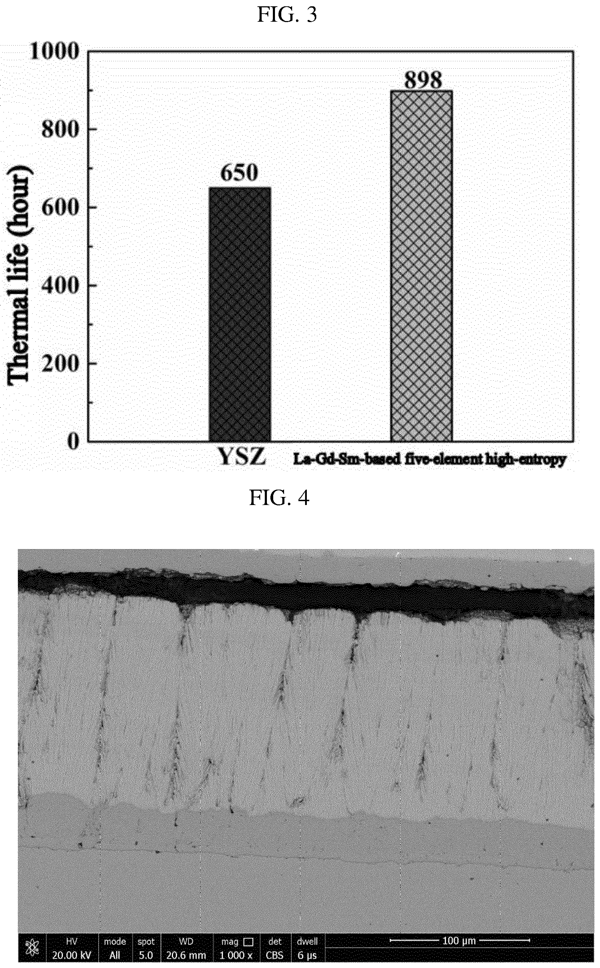

As shown in FIG. 1, the thermal conductivity of the prepared lanthanum-gadolinium-samarium-based high-entropy thermal barrier coating is greatly reduced compared with that of a YSZ material. As shown in FIG. 2, the thermal expansion coefficient of the prepared lanthanum-gadolinium-samarium-based high-entropy thermal barrier coating is comparable to that of the YSZ material by introducing the lanthanum-gadolinium-samarium-based high entropy. As shown in FIG. 3, the thermal life of the prepared lanthanum-gadolinium-samarium-based high-entropy thermal barrier coating is greatly increased by introducing the lanthanum-gadolinium-samarium-based high entropy. As shown in FIG. 4, the prepared lanthanum-gadolinium-samarium-based high-entropy thermal barrier coating has a typical columnar crystal structure and can well release thermal stress in a thermal cycling process.

Finally, it should be noted that the above embodiments are only used to illustrate the technical solutions of the invention, and the protection scope of the invention is not limited thereto. One of ordinary skill in the art can easily think of various equivalent modifications or replacements within the technical scope of the disclosure of the invention, and these modifications or replacements should fall within the protection scope of the invention.

## Claims

1. A lanthanum-gadolinium-samarium-based high-entropy thermal barrier coating material, wherein the lanthanum-gadolinium-samarium-based high-entropy thermal barrier coating material has a chemical molecular formula of La_{0.4}Gd_{0.4}Sm_{0.4}A_{0.4}B_{0.4}Zr₂O₇, where A and B are different rare earth elements other than lanthanum, gadolinium, and samarium.

2. The lanthanum-gadolinium-samarium-based high-entropy thermal barrier coating material according to claim 1, wherein the rare earth elements are Ce, Pr, Nd, Yb, Er, Dy, or Eu.

3. A method for preparing the lanthanum-gadolinium-samarium-based high-entropy thermal barrier coating material of claim 1, wherein the method comprises the following steps:
Step One, mixing raw materials La₂O₃, Gd₂O₃, Sm₂O₃, A₂O₃, B₂O₃ and ZrO₂ according to a ratio of the molecular formula of the material, and synthesizing a lanthanum-gadolinium-samarium-based high-entropy target material by a high-temperature solid-state method at a synthesis temperature of 2,000 °C to 2,200 °C;
Step Two, preparing NiCoCrAlYHf as a metal bottom layer of the thermal barrier coating by using a vacuum arc plating device at a voltage of 650 V to 700 V and a current of 15 A to 25 A; and
Step Three, mounting the lanthanum-gadolinium-samarium-based high-entropy target material into an electron beam physical vapor deposition device, and preparing the lanthanum-gadolinium-samarium-based high-entropy thermal barrier coating on the NiCoCrAlYHf bottom layer by electron beam evaporation of the lanthanum-gadolinium-samarium-based high-entropy target material at a beam intensity of the electron beam of 1.6 A to 1.8 A and a temperature of the sample of 1,000 °C to 1,050 °C;

4. The method for preparing the lanthanum-gadolinium-samarium-based high-entropy thermal barrier coating of claim 1, wherein in Step One, the raw materials La₂O₃, Gd₂O₃, Sm₂O₃, A₂O₃, B₂O₃ and ZrO₂ have purities of more than or equal to 99%.

5. The method for preparing the lanthanum-gadolinium-samarium-based high-entropy thermal barrier coating of claim 1, wherein in Step One, the mixing of the raw materials is by mechanical ball milling for a time more than or equal to 16 hours.

6. The method for preparing the lanthanum-gadolinium-samarium-based high-entropy thermal barrier coating of claim 1, wherein in Step One, a synthesis time of the high-temperature solid-state method is more than or equal to 20 hours.

7. The method for preparing the lanthanum-gadolinium-samarium-based high-entropy thermal barrier coating of claim 1, wherein in Step Two, the vacuum arc plating device has a vacuum degree of less than 1 × 10⁻² Pa and a deposition time of greater than or equal to 100 min.

8. The method for preparing the lanthanum-gadolinium-samarium-based high-entropy thermal barrier coating of claim 1, wherein in Step Three, the electron beam physical vapor deposition device has a vacuum degree of less than 5 × 10⁻² Pa.

9. The method for preparing the lanthanum-gadolinium-samarium-based high-entropy thermal barrier coating of claim 1, wherein in Step Three, the electron beam physical vapor deposition of the thermal barrier coating has an evaporation time of 30 min to 60 min.

10. The method for preparing the lanthanum-gadolinium-samarium-based high-entropy thermal barrier coating of claim 1, wherein in Step Three, the thermal barrier coating deposited by the electron beam physical vapor deposition is cooled inside the device to below 200 °C, the cooling being natural cooling.
